# EUROPÄISCHE PATENTSCHRIFT

(11) **EP 2 157 438 B1**
(45) Veröffentlichungstag und Bekanntmachung des Hinweises auf die Patenterteilung: **12.10.2011**
(21) Anmeldenummer: 08014923.0
(22) Anmeldetag: 22.08.2008
(51) Int. Cl.: G01R 31/08, G01R 31/11

(54) **Verfahren zum Betrieb einer Endeinrichtung in einem Kommunikationssystem und korrespondierende Endeinrichtung**
Method for operating an end device in a communication system and corresponding end device
Procédé de fonctionnement d'un terminal dans un système de communication et terminal correspondant

(43) Veröffentlichungstag der Anmeldung: 24.02.2010
(73) Patentinhaber: Siemens Aktiengesellschaft, 80333 München (DE)
(72) Erfinder: Weber, Karl, Dr., 90518 Altdorf (DE)

(56) Entgegenhaltungen:
- WO-A-01/26290
- US-A1- 2002 021 676
- US-A1- 2006 181 283

## Beschreibung

Die Erfindung betrifft ein Verfahren zum Betrieb einer Kommunikationsendeinrichtung. Als Kommunikationsendeinrichtung wird dabei eine Einrichtung im Sinne eines separaten Gerätes oder eine Funktionalität in einem Gerät mit weiteren Funktionen aufgefasst, die zum Anschluss an ein Kommunikationsmedium nach Art eines Busses vorgesehen ist und für Geräte, insbesondere Automatisierungsgeräte, die auf die Einrichtung oder die Funktionalität Zugriff haben, eine Kommunikationsmöglichkeit mit anderen, ebenfalls an das Kommunikationsmedium angeschlossenen Geräten ermöglicht.

Derartige Endeinrichtungen sind an sich bekannt und bei Geräten der hier in Rede stehenden Art, also Geräten mit einer Verarbeitungseinheit nach Art eines Prozessors, einem Speicher, in dem ein Computerprogramm vorgehalten werden kann, das durch die Verarbeitungseinheit ausführbar ist, insbesondere Automatisierungsgeräten wie nachfolgend ausgeführt, handelt es sich bei der Endeinrichtung um eine Funktionalität zum Netzwerkanschluss, also z.B. eine Netzwerkkarte oder eine Teilfunktionalität, wie sie auf einer solchen Netzwerkkarte realisiert sein kann.

Der Begriff "Automatisierungsgerät" umfasst sämtliche Geräte, Einrichtungen oder Systeme, also neben z.B. Steuerungen, wie speicherprogrammierbaren Steuerungen, Prozessrechnern, (Industrie-)Computern und dergleichen, auch Antriebssteuerungen, Frequenzumrichter und Ähnliches, wie sie zur Steuerung, Regelung und/oder Überwachung technologischer Prozesse, z.B. zum Umformen oder Transportieren von Material, Energie oder Information etc., eingesetzt werden oder einsetzbar sind, wobei insbesondere über geeignete technische Einrichtungen, wie z.B. Sensoren oder Aktoren, Energie aufgewandt oder gewandelt wird.

Insbesondere bei der industriellen Kommunikation, also einer Kommunikation zwischen Geräten der vorgenannten Art, wenn diese zur Steuerung und/oder Überwachung eines technischen Prozesses bestimmt sind, also eine Automatisierungslösung realisieren, ist die Verkabelungstechnik ein wesentlicher Schwachpunkt, weil meist keine vorkonfektionierten Kabel als Kommunikationsmedium verwendbar sind. So ist z.B. das Verbinden von Kabel und Stecker eine sehr verbreitete Fehlerquelle, die z.B. dann besonders kritisch wird, wenn derartige Fehler erst durch Umwelteinflüsse wirksam werden, etwa aufgrund von Vibration oder extremen Bewegungsvorgängen wie Beschleunigen oder Bremsen. Ein weiteres kritisches Szenario ist eine mechanische Vorschädigung, die durch eine zusätzliche elektrische Störung zum Ausfall führt. Bekannte Kommunikationsendeinrichtungen sind zwar so ausgelegt, dass sie bis zu einem bestimmten Niveau "fehlertolerant" sind. Darüber hinaus fallen sie allerdings mitunter relativ abrupt aus.

Verkabelungsprobleme können durch so genannte Reflektionsmessungen aufgedeckt werden. Wenn ein Impuls in ein Kabel als Kommunikationsmedium eingeleitet wird, wird ein Teil des Signals reflektiert, wenn sich entlang des Kommunikationsmediums an einem bestimmten Punkt dessen elektrische Eigenschaft (Impedanz) ändert. Geräte, die nach diesem Grundprinzip Störstellen eines Kommunikationsmediums erkennen können, sind an sich bekannt. Allerdings haben diese Geräte den Nachteil, dass die jeweiligen Messungen nur während eines Ruhezustands des jeweiligen technischen Prozesses durchgeführt werden können, wenn also keine Nutzdaten zwischen einzelnen Geräten übertragen werden. Damit fehlt der mechanische und elektrische Stress, der mitunter wesentlich zur Störung beiträgt, so dass die Störungsanalyse nur für den Ruhezustand tatsächlich aussagekräftig ist.

Für den unter der Bezeichnung PROFIBUS bekannten Standard für die Feldbus-Kommunikation in der Automatisierungstechnik wurde mittels eines so genannten Diagnoserepeaters eine derartige Reflektionsanalyse erstmals online möglich. Die Rahmenbedingungen dafür waren aber besonders günstig, weil bei Datenübertragungen entsprechend dem für PROFIBUS definierten Protokoll zwischen einzelnen für die Datenübertragung gebildeten, so genannten Frames eine Pause spezifiziert ist, die größer ist als die doppelte Signallaufzeit auf dem Kommunikationsmedium. Wird also eine Reflektionserkennung zu Beginn eines Frames aktiviert, kann davon ausgegangen werden, dass eine etwaige Reflektion nicht durch ein reflektiertes Signal des vorherigen Frames hervorgerufen wurde. Anhand einer Zeitdifferenz zwischen dem Beginn eines Frames und dem Eintreffen einer evtl. Reflektion ist auch die Entfernung der jeweils als Sender fungierenden Endeinrichtung zur Störstelle ermittelbar.

Bei dem unter der Bezeichnung Ethernet bekannten Standard für in Datennetzen kommunikativ verbundene Geräte gibt es keine derartige Ruhepause, so dass bei Ethernet ein Ansatz wie oben skizziert zur Lösung des Problems nicht verwendbar ist. Für Ethernet sind Zähler vorgesehen, in denen statistische Informationen zu Datenübertragungsvorgängen vorgehalten werden und die dazu benutzt werden könnten, Fehler wie oben skizziert zu erkennen. Allerdings ist die Aussagekraft solcher Zähler begrenzt und Störstellen sind nicht in jedem Falle sicher als solche erkennbar, wobei sich speziell auch der Ort einer solchen Störstelle nicht lokalisieren lässt. Ein Handlungsbedarf für die Beseitigung evtl. Störstellen wird letztendlich dadurch signalisiert, dass Fehler dazu führen, dass eine bestimmte Verbindung nicht mehr aufgebaut werden kann oder die Verbindung zwischen zwei Knoten häufig ausfällt. Dies ist aber meist eine späte Erkenntnis, die speziell im Bereich der Automatisierung technischer Prozesse bestenfalls eine suboptimale Lösung darstellt, wobei zudem nur schwer erkennbar ist, ob eingeleitete Maßnahmen wirklich erfolgreich waren.

In der US 2006/0181283 A ist ein Ansatz zur Reflektionsanalyse auf Basis der Zeitbereichsreflektometrie (Time Domain Reflectometry = TDR) beschrieben. Das reflektierte Signal wird hinsichtlich seiner Maxima (peaks) untersucht, indem Ort und Amplitude einzelner Maxima für nachfolgende Auswertungen gespeichert werden. Die US 2002/0021676 A nennt ebenfalls die Zeitbereichsreflektometrie als Ansatz zur Reflektionsanalyse.

Die WO 01/26290 A beschreibt ein Verfahren, bei dem die Zeitbereichsreflektometrie angewendet wird, während im Netzwerk Leerlaufsignale (idle signals) übertragen werden, wobei in einer empfangenen Reflektion die Leerlaufsignale durch eine inverse Faltung entfernt werden.

Eine Aufgabe der vorliegenden Erfindung besteht entsprechend darin, ein Verfahren zum Betrieb einer Kommunikationsendeinrichtung, im Folgenden kurz als Endeinrichtung bezeichnet, anzugeben, mit dem bei Ethernet eine Erkennung von evtl. Störstellen eines Kommunikationsmediums kontinuierlich oder zu vorgegebenen oder vorgebbaren Zeitpunkten und damit während des Betriebs eines gesteuerten und/oder überwachten technischen Prozesses durchgeführt werden kann, also parallel zu einer Übertragung von Nutzdaten über das Kommunikationsmedium.

Diese Aufgabe wird mit den Merkmalen des Anspruchs 1 gelöst. Dazu ist bei einem Verfahren zum Betrieb einer Endeinrichtung der eingangs genannten Art an einem für eine Datenübertragung, insbesondere eine Datenübertragung nach dem Ethernet Protokoll, vorgesehenen Kommunikationsmedium, bei dem im Anschluss an einen Sendevorgang der Endeinrichtung eventuelle Reflektionen auf dem Kommunikationsmedium auf das Vorkommen einer vorgegebenen Signatur überwacht werden, vorgesehen, dass zum Überwachen der Reflektion auf das Vorkommen der Signatur aus der Reflektion ein gespeichertes Nutzdatensendesignal herausgefiltert wird, so dass im Falle einer Detektion der vorgegebenen Signatur eine Störstelle des Kommunikationsmediums erkannt ist. Dabei ist die vorgegebene Signatur ein am Ende eines Sendevorgangs vorgesehenes Idle-Symbol einer 4B5B MLT-3-Kodierung.

Die Erfindung geht dabei von der Erkenntnis aus, dass bei einer außerhalb von Ruhepausen, also während laufender Sendevorgänge, durchgeführten Reflektionsmessung eine Überlagerung des sich bei der Datenübertragung ergebenden Nutzdatensendesignals mit einer evtl. Reflektion stattfindet. Eine von dem Nutzdatensendesignal ggf. umfasste Signatur ist entsprechend in der Reflektion nicht unmittelbar erkennbar. Wenn allerdings das Nutzdatensendesignal teilweise zwischengespeichert wird, kann durch ein Herausfiltern des zwischengespeicherten Abschnitts des Nutzdatensendesignals die Überlagerung teilweise wieder rückgängig gemacht werden, so dass nach einer solchen Filterung als Reflektion diejenigen Signalabfolgen erkennbar/auswertbar sind, wie sie sich ergeben würden, wenn die Reflektionsmessung während einer Ruhepause, also ohne Nutzdatensendesignal, durchgeführt worden wäre. Dann wird in der Reflektion auch eine von der ursprünglichen Datenübertragung umfasste Signatur erkennbar, und mit Erkennen einer solchen Signatur kann davon ausgegangen werden, dass die empfangene Reflektion sich aufgrund einer auf dem Kommunikationsmedium vorhandenen Störstelle ergeben hat, so dass im Ergebnis das Vorhandensein einer Störstelle erkannt ist.

Der Vorteil der Erfindung besteht in der sicheren Erkennbarkeit von Störstellen im laufenden Betrieb, d.h. ohne dass dafür artifiziell Sendepausen geschaffen werden müssten, z.B. durch kurzfristige Unterbrechung der Datenübertragung, wobei eine solche Unterbrechung der Datenübertragung häufig, insbesondere wenn diese für die sichere Steuerung und/oder Überwachung eines technischen Prozesses erforderlich ist, nicht möglich ist oder zumindest auch eine Unterbrechung des technischen Prozesses erfordert und dementsprechend zeit- und kostenaufwändig ist.

Vorteilhafte Ausgestaltungen der Erfindung sind Gegenstand der Unteransprüche. Dabei verwendete Rückbeziehungen weisen auf die weitere Ausbildung des Gegenstandes des Hauptanspruches durch die Merkmale des jeweiligen Unteranspruches hin; sie sind nicht als ein Verzicht auf die Erzielung eines selbständigen, gegenständlichen Schutzes für die Merkmalskombinationen der rückbezogenen Unteransprüche zu verstehen. Des Weiteren ist im Hinblick auf eine Auslegung der Ansprüche bei einer näheren Konkretisierung eines Merkmals in einem nachgeordneten Anspruch davon auszugehen, dass eine derartige Beschränkung in den jeweils vorangehenden Ansprüchen nicht vorhanden ist.

Die Verwendung des Idle-Symbols hat den Vorteil, dass das Idle-Symbol gemäß dem Ethernet-Protokoll stets im Anschluss an eine Übertragung von Nutzdaten gesendet wird. D.h. das Idle-Symbol wird automatisch erzeugt und in die Datenübertragung muss kein zusätzliches Datum eingefügt werden.

Eine MLT-3 Kodierung (Multilevel Transmission Encoding - 3 levels) ist ein zur Datenübertragung verwendetes Verfahren mit drei Spannungspegeln (+, 0, -) (ternäres Signal). MLT-3 ändert bei einer logischen Eins im Datenstrom den Signalpegel. Dabei wird stets der nächste Pegel in der Folge 0, +, 0, -, 0, +, 0, -,... verwendet. Dadurch werden der Gleichstromanteil und die Bandbreite verringert. Bei einer logischen Null bleibt der Signalpegel gleich. Eine 4B5B Kodierung ist eine Kodierung, die ein 4-Bit Datum in ein 5-Bit Datum umwandelt, um lange Folgen gleich bleibender Pegel zu vermeiden, die eine Taktrückgewinnung erschweren könnten. Bei einer Verwendung von 4B5B vor MLT-3, also in Kombination, wird sicherstellt, dass nie mehr als drei logische Nullen aufeinander folgen, so dass sich eine Bandbreitenreduktion ergibt und eine Taktrückgewinnung möglich wird.

Das Idle-Symbol in 4B5B Kodierung umfasst fünf aufeinander folgende Einsen, also logische High-Pegel. Durch die nachfolgende MLT-3 Kodierung wird daraus eine alternierende Pegelfolge, z. B. - je nach letztem Pegel des vorangehenden Symbols - "0", "+", "0", "-", "0", und damit eine besonders charakteristische Signalfolge, die von den sonstigen Symbolen einer 4B5B Kodierung besonders gut unterscheidbar ist. Vorteilhaft wird eine Position der Störstelle entlang des Kommunikationsmediums anhand einer Signallaufzeit ermittelt, und zwar aus einer vom Ende des Sendevorgangs bis zum Erkennen der Signatur gemessenen hälftigen Signallaufzeit, die durch die Signalausbreitungsgeschwindigkeit auf dem Kommunikationsmedium ermittelt dividiert wird. Damit lässt sich die Position der Störstelle mit einer Genauigkeit von bis zu einem Meter ermitteln. Es ist also nicht nur feststellbar, ob eine Störstelle vorliegt, sondern es kann auch noch eine hinsichtlich der Position der Störstelle abgeleitet werden, wodurch eine Fehlerbehebung natürlich ernorm vereinfacht wird.

Durch zusätzliche Auswertung der Signatur können im Falle einer vorliegenden Störung auch Informationen im Hinblick auf die Art der Störstelle ermittelt werden. In dieser Hinsicht ist vorteilhaft vorgesehen, dass bei einer gleichsinnigen Erkennung der Signatur in einer Reflektion auf dem Kommunikationsmedium die Störstelle als Leitungsbruch, also als offene Leitung, erkannt wird. Gleichsinnige Erkennung der Signatur meint, dass die Signatur in der Reflektion genauso enthalten ist, wie sie in dem ursprünglichen Nutzdatensendesignal erhalten war, also mit gleicher Pegelart und gleicher Pegelfolge. Bei einer antivalenten Erkennung der Signatur ist die Störstelle als Kurzschluss erkennbar. Antivalente Erkennung meint hier, dass die Signatur in der Reflektion mit einer zur Pegelfolge der Signatur im Nutzdatensendesignal antivalenten (also umgekehrten) Pegelfolge enthalten ist. Diese Aussagen lassen sich in Bezug auf die Störstelle aufgrund der Erkenntnis, dass bei einem Leitungsbruch, also einer "offenen" Leitung / einer unendlichen Eingangsimpedanz, an der Störstelle eintreffende Pegel unverändert reflektiert werden, während bei einem Kurzschluss (Eingangsimpedanz bei Null) eintreffende Pegel invertiert reflektiert werden.

Besonders vorteilhaft ist vorgesehen, dass Reflektionen auf dem Kommunikationsmedium auf das Vorkommen des Idle-Symbols als Signatur überwacht werden, indem eine Auswertelogik im Falle zweier aufeinander folgender gleichsinniger Pegelwechsel das unmittelbar daran anschließende Vorkommen zweier aufeinander folgender antivalenter Pegelwechsel überwacht. Das Idle-Symbol in 4B5B MLT-3 Kodierung umfasst nämlich, auch wenn dessen Pegelfolge je nach letztem Pegel des vorangehenden Symbols variieren kann, nämlich "0-0+0" oder "+0-0+" oder "0+0-0", stets zwei aufeinander folgende gleichsinnige Pegelwechsel, z. B. von "+" nach "0" und danach von "0" nach "-", und danach nochmals zwei aufeinander folgende gleichsinnige Pegelwechsel, die zudem zu den ersten beiden Pegelwechseln antivalent sind, also z.B. von "-" nach "0" und danach von "0" nach "+". Anhand dieser Charakteristik ist das Idle-Symbol zumindest in erster Näherung erkennbar, so dass eine Überwachung der Pegelwechsel, wie beschrieben, zur Identifizierung des Idle-Symbols in einer evtl. Reflektion herangezogen werden kann.

Weiter vorteilhaft ist vorgesehen, dass im Falle einer Erkennung zweier aufeinander folgender antivalenter Pegelwechsel nach Erkennung der ersten beiden aufeinander folgenden gleichen Pegelwechsel ein Zähler inkrementiert wird und wobei die Störstelle als solche erkannt ist, wenn der Zähler einen vorgegebenen oder vorgebbaren Schwellwert erreicht. Die Erkennung zweier aufeinender folgender gleicher Pegelwechsel und danach die Erkennung zweier aufeinander folgender antivalenter Pegelwechsel ist eine notwendige Voraussetzung dafür, dass die von der Reflektion umfasst Pegelfolge von einem ursprünglich gesendeten Idle-Symbol herrührt. Allerdings haben auch andere Symbole abschnittsweise eine ähnliche Charakteristik wie das Idle-Symbol, so dass die einmalige Erkennung zweier gleicher Pegelwechsel und zweier daran anschließender, antivalenter gleicher Pegelwechsel keine absolute Sicherheit für die Detektion eines Idle-Symbols liefert. Nachdem Idle-Symbole entsprechend dem für Ethernet definierten Protokoll immer mehrfach hintereinander übertragen werden, kann ein Zähler verwendet werden, der immer dann inkrementiert wird, wenn eine Pegelfolge erkannt wurde, die potentiell von einem Idle-Symbol herrührt. Wenn nämlich zweimal hintereinander eine solche Pegelfolge erkannt ist, der Zähler entsprechend einen Schwellwert von z.B. Zwei erreicht oder überschreitet, steht mit Sicherheit fest, dass die Reflektion ein Idle-Symbol umfasst hat, und Mehrdeutigkeiten, die sich aufgrund abschnittsweise ähnlicher Charakteristik anderer Symbole ergeben, sind eliminiert.

Gemäß einer weiteren vorteilhaften Ausführungsform ist vorgesehen, dass nach einer Datenübertragung bei einem Übergang zu einer Sendepause ein Pauseneinleitungssymbol und daran anschließend zumindest zweimal oder fortdauernd bis zum Ende der Sendepause das Idle-Symbol gesendet wird, wobei mit der Übertragung des Pauseneinleitungssymbols ein Zeitzähler gestartet wird, der mit dem Erkennen des Idle-Symbols in einer eventuellen Reflektion gestoppt wird und wobei der dann erhaltene Wert des Zeitzählers als Signallaufzeit verwendet wird. Die Verwendung des Pauseneinleitungssymbols kann also als Basis für einen definierten Startzeitpunkt eines Zeitzählers herangezogen werden. Mit der sich dann ergebenden Signallaufzeit kann mit der bekannten Signalausbreitungsgeschwindigkeit, wie oben bereits beschrieben, die Position der Störstelle relativ genau ermittelt werden.

Zur nochmals genaueren Analyse des Kommunikationsmediums auf Störstellen ist gemäß einer weiteren bevorzugten Ausführungsform vorgesehen, dass in einem während des Sendevorgangs übermittelten Nutzdatensendesignal davon umfasste Flanken und ebenfalls in einer eventuellen Reflektion davon umfasste Flanken gezählt werden und ein Quotient gebildet wird, wobei bei einem Quotienten in der Nähe von Eins die Störung auf dem Kommunikationsmedium und ein Fehlerort ausgegeben werden und wobei bei einem Quotienten, der klein gegen Eins ist, die Störung auf dem Kommunikationsmedium als durch mehrere Störstellen verursacht ausgegeben wird. Dieser Ausführungsform der Erfindung liegt die Erkenntnis zugrunde, dass bei einer einzigen Störstelle auf dem Kommunikationsmedium diese Störstelle zu genau einer Reflektion des Nutzdatensendesignals führt, d.h. normalerweise entspricht die Anzahl der von einem Nutzdatensendesignal umfassten Flanken der Anzahl der von der Reflektion umfassten Flanken. Eine Identität wird sich in der Praxis möglicherweise nicht einstellen, weil z.B. die Pegelhöhe der Reflektion gegenüber einer Pegelhöhe des Nutzdatensendesignals reduziert ist und einzelne Flanken insoweit nicht erkannt werden, weil einzelne Flanken aufgrund von Überlagerungen ausgelöscht werden, etc. Insofern ist für eine Aussage, wonach auf einem Kommunikationsmedium genau eine Störstelle erkannt wurde auf eine zumindest im Wesentlichen gleiche Anzahl von Flanken in *Nutzdatensendesignal* und Reflektion, also einen Quotienten "nahe bei Eins", abzustellen. Wenn auf dem Kommunikationsmedium dagegen mehrere Störstellen vorhanden sind, für grundsätzlich jede Störstelle zu einer Reflektion des Nutzdatensendesignals, d.h. für die Reflektion kann im Vergleich zum Nutzdatensendesignal zumindest eine deutlich erhöhte Flankenanzahl erwartet werden, je nachdem, wie der Quotient der Flankenzahlen gebildet wird, ergibt sich ein Wert "klein gegen Eins" oder "gross gegen Eins", der entsprechend ausgewertet werden kann, so dass als Fehlermeldung zumindest die Information ausgegeben werden kann, dass entlang des Kommunikationsmediums eine Mehrzahl von Störstellen vorliegt. Möglicherweise kann hier, wenn der Quotient in der Nähe von "0,5" bzw. "2" oder "0,33" oder "3" liegt, noch angegeben werden, dass entlang des Kommunikationsmediums voraussichtlich zwei bzw. drei Störstellen vorliegen, wegen mehrfacher Reflektionen also auch Reflektion bereits reflektierter Pegel, ist eine solche Aussage, insbesondere wenn mehr als drei Störstellen hinsichtlich ihrer Anzahl angegeben werden sollen, mit gewissen Unsicherheiten behaftet. Allerdings kann, wenn die Flankenanzahl in dem Nutzdatensendesignal gegenüber einer Flankenanzahl in einer Reflektion sehr groß ist, auf die Fehlerfreiheit des Kommunikationsmediums geschlossen und auch eine solche Information ausgegeben werden, um die Fehleranalyse mit einer konkreten "gut-Aussage" für den Bediener noch aussagekräftiger zu machen.

Das oben skizzierte Verfahren mit seinen Ausgestaltungen, das nachfolgend näher beschrieben wird, ist bevorzugt in Software implementiert, wobei hier von dem Begriff softwareimplemeniert auch solche Implementierungen umfasst sind, bei denen das Verfahren als Logik (z.B. in einem ASIC, FPGA und dergleichen) oder Microcode in Kommunikationsendeinrichtung implementiert ist, so dass die Erfindung auch ein Computerprogramm zur Ausführung des Verfahrens, wie hier und nachfolgend beschrieben, betrifft. Das Computerprogramm (der Microcode, die Logik, usw.) umfasst dazu an sich bekannte Programmcodeanweisungen, wie sie zur Implementierung des Verfahrens erforderlich sind. In gleicher Weise betrifft die Erfindung auch einen Datenträger mit einem solchen Computerprogramm oder ein Computersystem, insbesondere eine Kommunikationsendeinrichtung, auf der ein solches Computerprogramm geladen ist.

Die oben genannte Aufgabe wird auch mit einer Endeinrichtung mit den Merkmalen des unabhängigen Vorrichtungsanspruchs gelöst. Dazu sind bei einer Endeinrichtung der eingangs genannten Art Mittel zum Ausführen des Verfahrens wie weiter oben skizziert und nachfolgend weiter erläutert vorgesehen. Bevorzugt handelt es sich bei solchen Mitteln um eine Verarbeitungseinheit nach Art eines Prozessors oder dergleichen und einen in den Speicher geladenen Computerprogramm, mit dem das erfindungsgemäße Verfahren oder einzelne oder mehrere Ausführungsformen realisiert sind.

Weiter bevorzugt sind bei einer besonderen Ausführungsform der Endeinrichtung ein Pufferspeicher und ein Filter vorgesehen, wobei in dem Pufferspeicher während eines Sendevorgangs der Endeinrichtung übermittelte Daten als Nutzdatensendesignal speicherbar sind und mit dem Filter aus einer evtl. Reflektion das im Pufferspeicher vorgehaltene Nutzdatensendesignal herausfilterbar ist. Der Pufferspeicher kann als Schiebespeicher realisiert sein, so dass stets eine bestimmte, durch die Größe des Speichers vorgegebene Anzahl von Pegeln zwischengespeichert wird, wobei durch den Schiebevorgang bei der Verwendung des Puffers sichergestellt ist, dass aus einem Nutzdatensendesignal stets die letzten "n" Pegel zwischengespeichert und zur Filterung zur Verfügung stehen, wobei die Variable "n" durch die Größe des Speichers festgelegt ist. Zur Realisierung einzelner bevorzugter Ausführungsformen des beschriebenen Verfahrens muss der Pufferspeicher Kapazität für zumindest zehn aufeinander folgende Pegel, d.h. zwei Symbole in 4B5B Kodierung, haben.

Eine Endeinrichtung, mit der zwei aufeinander folgende Idle-Symbole erkennbar sind und mit der entsprechend, wie vorstehend bei der Erläuterung der zugrunde liegenden Verfahrensaspekte bereits beschrieben, sicher erkannt werden kann, dass die Reflektion zumindest ein Idle-Symbol umfasst hat, weist vorteilhaft eine Auswertelogik auf, die Mittel zum Erkennen bestimmter Pegel eventueller Reflektionen auf dem Kommunikationsmedium, Mittel zum Erkennen zweier aufeinander folgender gleicher Pegelwechsel, Mittel zum Erzeugen einer ersten Statusinformation im Falle erkannter gleicher Pegelwechsel, Mittel zum Erzeugen einer zweiten Statusinformation im Falle erkannter gleicher antivalenter Pegelwechsel bei Vorliegen der ersten Statusinformation und Mittel zur Weiterverarbeitung der zweiten Statusinformation umfasst. Eine derartige Auswertelogik ist bevorzugt in Software implementiert, so dass die davon umfassten Mittel Software-Module sind, die die jeweilige Funktionalität bereitstellen, wobei "Mittel zum Erzeugen einer zweiten Statusinformation" eine Beschreibung für einen in Software realisierten Zähler sein kann und der jeweilige Zählerstand entsprechend die Statusinformation repräsentiert, etc.

Bei einer bevorzugten weiteren Konkretisierung der vorgenannten Ausführungsform ist vorgesehen, dass zur Weiterverarbeitung der zweiten Statusinformation diese einem Zähler an dessen Eingang zuführbar ist und dem Zähler eine Schwellwertüberwachung nachgeschaltet ist, mit dem, wenn im Betrieb der Zähler einen der Schwellwertüberwachung vorgegebenen oder vorgebbaren Schwellwert erreicht, ein eine Störstelle auf dem Kommunikationsmedium anzeigendes Fehlersignal generierbar ist.

Weitere Einzelheiten der Erfindung werden nachfolgend anhand eines Ausführungsbeispiels mit Bezug auf die Zeichnung näher erläutert. Einander entsprechende Gegenstände oder Elemente sind in allen Figuren mit den gleichen Bezugszeichen versehen. Das oder jedes Ausführungsbeispiel ist nicht als Einschränkung der Erfindung zu verstehen. Vielmehr sind im Rahmen der vorliegenden Offenbarung zahlreiche Abänderungen und Modifikationen möglich, insbesondere solche Varianten und Kombinationen, die zum Beispiel durch Kombination oder Abwandlung von einzelnen in Verbindung mit den im allgemeinen oder speziellen Beschreibungsteil beschriebenen sowie in den Ansprüchen und/oder der Zeichnung enthaltenen Merkmalen bzw. Elementen oder Verfahrensschritten für den Fachmann im Hinblick auf die Lösung der Aufgabe entnehmbar sind und durch kombinierbare Merkmale zu einem neuen Gegenstand oder zu neuen Verfahrensschritten bzw. Verfahrensschrittfolgen führen.

Es zeigen
- FIG 1: zwei mittels jeweils einer Endeinrichtung an einen Bus angeschlossener und über den Bus als Kommunikati- onsmedium kommunikativ verbundene Geräte,
- FIG 2: eine schematische Darstellung eines bei der Kommuni- kation zwischen zwei Geräten ausgetauschten Nutzda- tensendesignal mit einer davon umfassten Signatur,
- FIG 3: eine 4B5B Kodierung einzelner Zahlenwerte,
- FIG 4: ein Darstellung zur Erläuterung einer MLT-3 Kodie- rung,
- FIG 5: ein als Signatur in Frage kommendes Idle-Symbol als ternäres Signal,
- FIG 6: eine Endeinrichtung mit weiteren Details zur Überwa- chung von evtl. Reflektionen auf dem Kommunikations- medium auf das Vorkommen einer vorgegebenen Signatur, insbesondere eines Idle-Symbols,
- FIG 7: eine von der Endeinrichtung umfasste Auswertelogik mit einem Flussdiagramm eines dort implementierten Software-Algorithmus zur Erkennung einer vorgegebenen Signatur,
- FIG 8: weitere Details einer besonders bevorzugten Ausfüh- rungsform der Endeinrichtung und
- FIG 9: nochmals weitere Details einer Ausführungsform der Endeinrichtung.

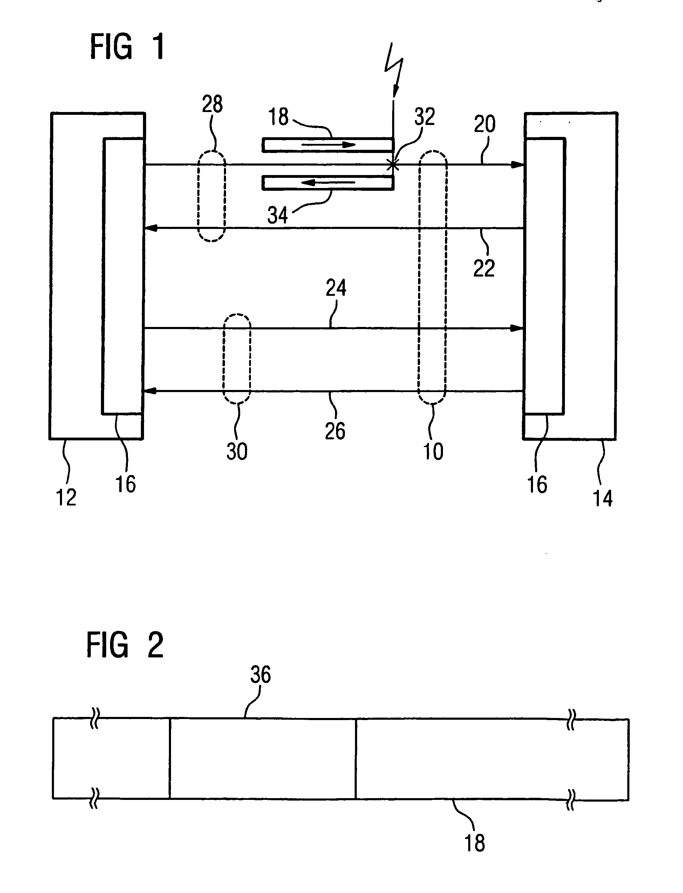

FIG 1 zeigt schematisch vereinfacht zwei mittels eines Kommunikationsmediums 10 kommunikativ miteinander verbundene Geräte 12, 14, z.B. Automatisierungsgeräte der eingangs genannten Art. Jedes Gerät 12, 14 umfasst eine Kommunikationsendeinrichtung (Endeinrichtung 16), die für das jeweilige Gerät 12, 14 in an sich bekannter Art physikalisch die Anbindung an das Kommunikationsmedium 10 ermöglicht und in ebenfalls an sich bekannter Art funktional zu sendende Daten in ein über das Kommunikationsmedium 10 übertragbares Nutzdatensendesignal 18 und umgekehrt ein über das Kommunikationsmedium 10 empfangenes Signal in verarbeitbare Daten umsetzt. Das Kommunikationsmedium 10 ist als für Ethernet charakteristische so genannte Vierdrahtleitung gezeigt, d.h. jeweils zwei Leitungen 20, 22, 24, 26 bilden einerseits einen Sende- und einen Empfangskanal 28, 30.

In FIG 1 ist eine Situation gezeigt, bei der das Kommunikationsmedium 10 fehlerhaft ist, also zumindest eine der Leitungen 20-26 eine Störstelle 32 aufweist. Eine Störstelle 32 ist dabei jede Position entlang des Kommunikationsmediums 10, an dem sich dessen elektrische Eigenschaft (Impedanz) ändert. An einer solchen Störstelle 32 wird jeder in die jeweilige Leitung 20-26 eingeleitete Impuls (teilweise) reflektiert. Zu dem ausgesandten Nutzdatensendesignal 18 ergibt sich also an der Störstelle 32 ein reflektiertes Signal, das im Folgenden kurz als Reflektion 34 bezeichnet wird.

FIG 2 zeigt schematisch vereinfacht das Nutzdatensendesignal 18 mit weiteren Details. Danach umfasst das Nutzdatensendesignal 18 zumindest eine Signatur 36, also eine vorgegebene oder vorgebbare charakteristische Signalfolge. Wenn ein Nutzdatensendesignal 18 (FIG 1) an einer Störstelle 32 (FIG 1) reflektiert wird, umfasst die sich ergebende Reflektion 34 (FIG 1) ebenfalls diese Signatur 36 und durch Auswertung der Reflektion 34 und deren Überwachung auf das Vorkommen der Signatur 36 werden gemäß dem Ansatz entsprechend der Erfindung evtl. Störstellen 32 entlang des Kommunikationsmediums 10 (FIG 1) erkannt.

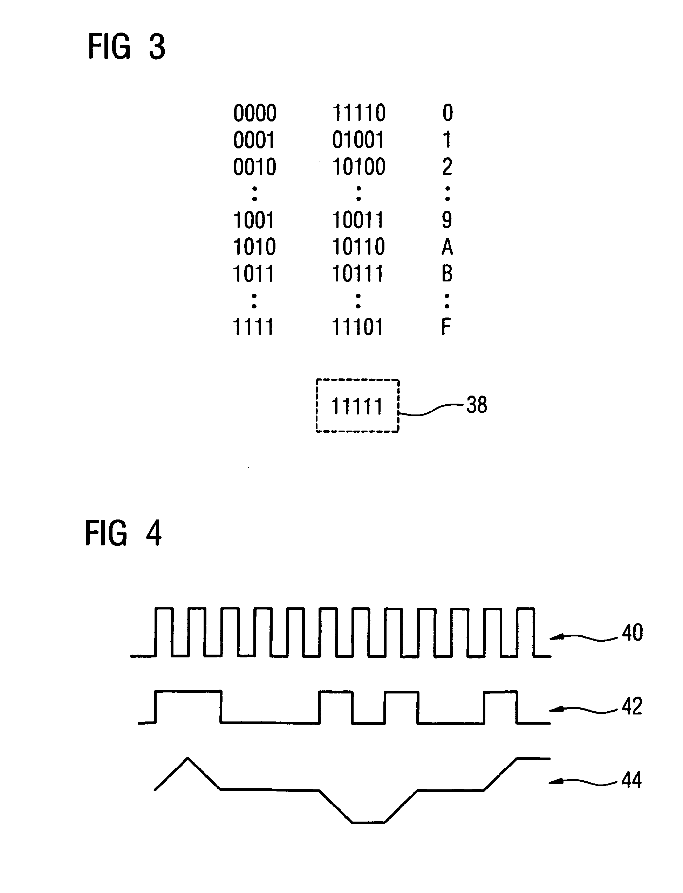

Zur weiteren Erläuterung einer speziellen Signatur, anhand derer die weitere Beschreibung fortgesetzt wird, ist in FIG 3 eine 4B5B Kodierung für die Zahlenwerte 0-15 (als entsprechend die Symbole "0" .. "F") und in FIG 4 eine MLT-3-Kodierung dargestellt. In FIG 3 sind in der linken Spalte die Werte 0-15 in Binärdarstellung und in der rechten Spalte die korrespondierenden Symbole 0-F. Entsprechend einer vorgegebenen Bildungsregel werden aus vier Bits fünf Bits und das Ergebnis dieser 4B5B Kodierung ist in der mittleren Spalte gezeigt. Neben den Symbolen 0-F gibt es noch weitere Symbole, von denen eines als Beispiel für eine Signatur 36 (FIG 2) in FIG 3 gezeigt ist, und diese spezielle Signatur 36 wird im Folgenden als Idle-Symbol 38 bezeichnet.

In FIG 4 ist zur schematischen Erläuterung der MLT-3-Kodierung zunächst ein Taktsignal 40 und darunter ein Datensignal 42 dargestellt, bei dem es sich um ein Binärsignal, also ein Signal mit zwei Pegeln, nämlich "high" und "low", handelt. Durch die MLT-3-Kodierung wird aus dem Datensignal 42 ein ternäres Signal 44 mit drei Pegeln, nämlich "+" (oder "high"), "0" und "-", wobei für die Ableitung des ternären Signals 44 aus dem Datensignal 42 gilt, dass bei einer logischen Eins ("high") im Datensignal 42 sich der Signalpegel des resultierenden ternären Signals 44 ändert, und zwar entsprechend der Folge "0, +, 0, -, 0, +, 0, -, ...", während bei einer logischen 0 ("low") im Datensignal 42 der Signalpegel des resultierenden ternären Signals 44 unverändert bleibt.

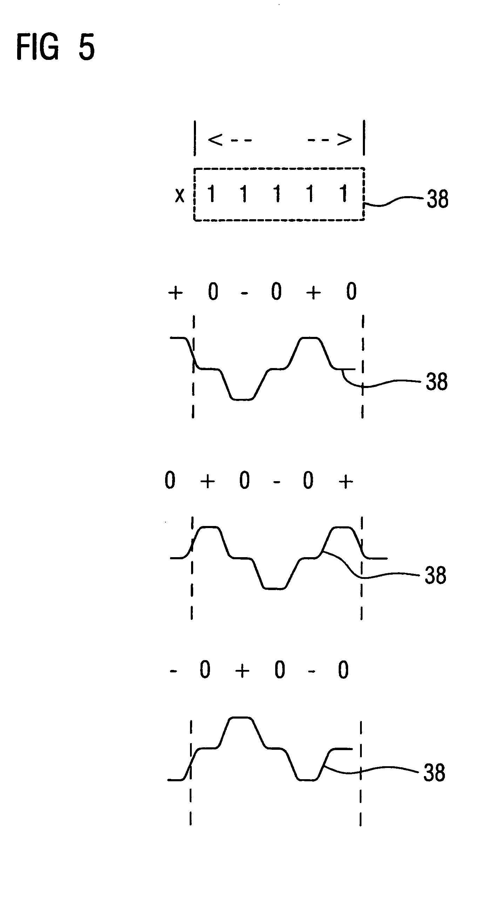

In FIG 5 ist dazu das Idle-Symbol 38 als ternäres Signal 44 dargestellt, und zwar, nachdem das resultierende ternäre Signal von dem letzten Pegel des dem Idle-Symbol 38 vorangehenden Symbols abhängig ist, für alle sich ergebenden Möglichkeiten. Man erkennt bei der Darstellung in FIG 5 eine besondere Eigenart des Idle-Symbols 38, die dieses für eine Verwendung als Signatur 36 (FIG 2) besonders geeignet erscheinen lässt. Das Idle-Symbol 38 umfasst als ternäres Signal 44 nämlich stets zwei Paare aufeinander folgender gleicher Pegelwechsel: Bei der ersten Darstellung einen ersten Übergang von "+" zu "0" als erstem Pegelwechsel und sodann von "0" zu "-" als zweitem Pegelwechsel, wobei diese beiden Übergänge das erste Paar gleicher Pegelwechsel bilden und wobei das zweite Paar gleicher Pegelwechsel durch den anschließenden Übergang von zunächst "-" zu "0" und sodann von "0" zu "+" gebildet wird. Bei der dargestellten zweiten möglichen Ausprägung des Idle-Symbols 38 als ternäres Signal 44 liegen die gleichen Übergänge wie zuvor beschrieben vor, jedoch verschoben. Bei der dritten möglichen Ausprägung des Idle-Symbols 38 als ternäres Signal 44 wird das erste Paar Pegelwechsel durch den Übergang von "-" zu "0" und sodann von "0" zu "+" gebildet, woran sich ein zweites Paar gleicher Pegelwechsel mit einem Übergang von zunächst "+" zu "0" und sodann von "0" zu "-" anschließt.

Diese Charakteristik des Idle-Symbols 38, dass das Idle-Symbol 38 also stets zwei aufeinander folgende gleiche Pegelwechsel und im Anschluss daran nochmals zwei aufeinander folgende gleiche Pegelwechsel umfasst, kann noch weiter konkretisiert werden, dahingehend, dass sich an zwei aufeinander folgende gleiche Pegelwechsel unmittelbar zwei aufeinander folgende antivalente, also entgegengesetzte Pegelwechsel anschließen.

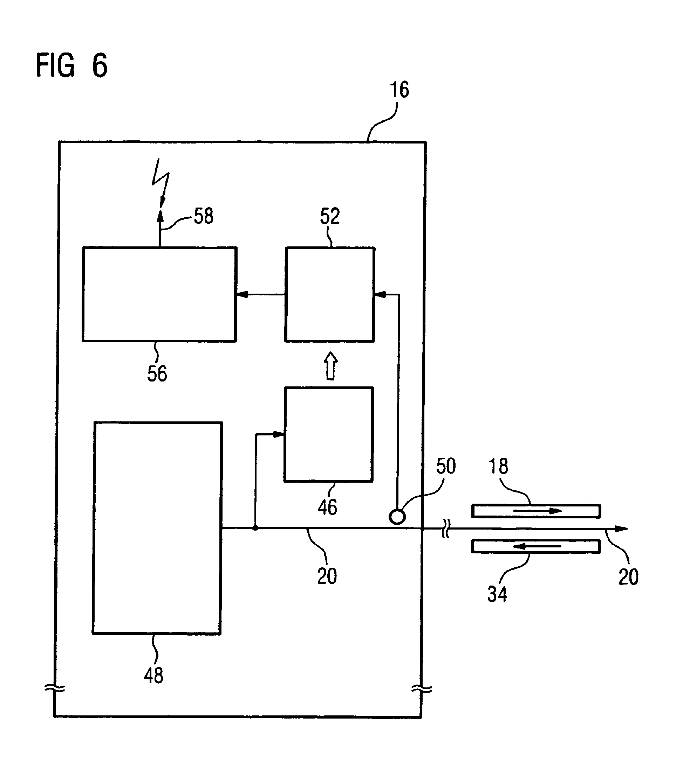

FIG 6 zeigt zur weiteren Erläuterung, wie evtl. Reflektionen 34 (FIG 1) auf dem Kommunikationsmedium 10 (FIG 1) auf das Vorkommen einer vorgegebenen Signatur 36 (FIG 2), insbesondere eines Idle-Symbols 38 (FIG 5) als Signatur 36, überwacht werden, eine mögliche Ausführungsform einer Endeinrichtung 16. Dazu umfasst die dargestellte Endeinrichtung 16 einen einer der Sendeleitungen 20 zugeordneten Pufferspeicher 46, in dem ein übertragenes Nutzdatensendesignal 18 zumindest teilweise zwischengespeichert wird. Der Pufferspeicher 46 kann dabei als Schiebespeicher realisiert sein, so dass stets die letzten Pegel des Nutzdatensendesignals 18 in dem Pufferspeicher 46 vorgehalten werden. Der Pufferspeicher 46 ist mit dem Ausgang einer grundsätzlich bekannten Umwandlungseinheit 48 verbunden, die zu übermittelnde Daten in das Format des Nutzdatensendesignals 18 umsetzt, also z.B. eine 4B5B-MLT-3-Kodierung vornimmt. Für die Erkennung evtl. Reflektionen 34 auf der Leitung 20 ist ein Abgriff 50 vorgesehen, mit dem die jeweilige Reflektion 34, also eine Überlagerung des momentanen Nutzdatensendesignals 18 mit an einer Störstelle 32 (FIG 1) reflektierten Pulsen, einem Filter 52 zugeführt wird. Mit dem Filter 52 wird aus der Reflektion 34 ein in dem Pufferspeicher 46 zwischengespeichertes Nutzdatensendesignal 18 herausgefiltert.

Am Ausgang des Filters 52 steht also die Reflektion 34 in einer Form zur Verfügung, wie sie sich ergeben würde, wenn beim Eintreffen der Reflektion 34 nicht gleichzeitig ein Nutzdatensendesignal 18 vorliegt, also quasi in Bezug auf den Betrieb der Endeinrichtung 16 eine Sendepause vorliegt. Das Ausgangssignal des Filters 52 wird einer Auswertelogik 56 zugeführt, in der zumindest ein Charakteristikum der zu erkennenden Signatur 36 hinterlegt ist und mit dem das Ausgangssignal des Filters 52 auf Übereinstimmung mit dem oder jedem Charakteristikum überwacht wird. Ergibt sich eine derartige Übereinstimmung, ist die vorgegebene Signatur 36 in der Reflektion 34 erkannt und wenn die vorgegebene Signatur 36 in dem Nutzdatensendesignal 18 enthalten war, ist damit erkannt, dass sich entlang der Leitung 20 eine Störstelle 32 befindet, die die Reflektion 34 hervorgerufen hat.

Ist eine Signatur 36 in der Reflektion 34 erkannt, wird ein diesbezügliches Ausgangssignal 58 generiert und ausgegeben, das in eine Information für den Benutzer in unterschiedlichsten Ausprägungen umgewandelt werden kann, z.B. in eine optische Anzeige. Die Bandbreite möglicher optischer Anzeigen reicht von der Aktivierung eines Anzeigeelements, etwa einer Leuchtdiode, bis zu einer Klartextmeldung auf einem Ausgabegerät, z.B. einem Bildschirm.

Es versteht sich, dass die für die Endeinrichtung 16 gezeigten Funktionalitäten, also Pufferspeicher 46, Filter 52 und Auswertelogik 56 einen gemeinsamen Takt für die Verarbeitung der jeweils vorliegenden Signale zugrunde legen, wobei dieser Takt der Taktung des Nutzdatensendesignals 18 entspricht und auch die Umwandlungseinheit 48 nach diesem Takt aus den zu übermittelnden Daten das Nutzdatensendesignal 18 generiert und dafür entweder selber das Taktsignal generiert oder dieses von einer externen Quelle erhält, so dass das Taktsignal entsprechend auch allen anderen genannten und dargestellten Funktionseinheiten zur Verfügung gestellt wird, ohne dass dies in der Darstellung ausdrücklich gezeigt ist.

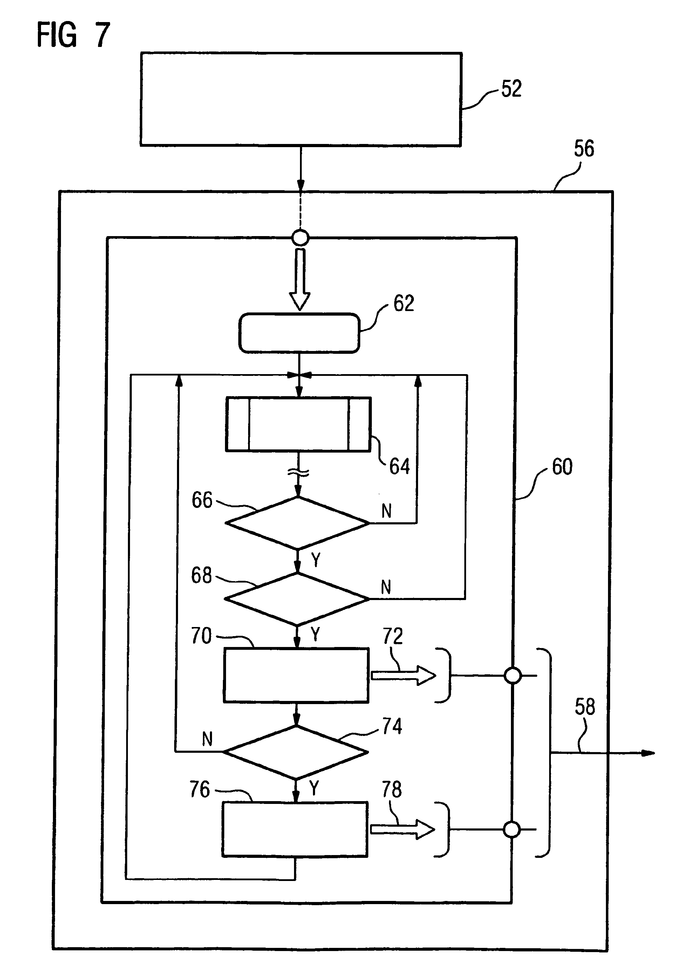

FIG 7 zeigt die Auswertelogik 56 mit weiteren Details. Die Funktionalität, die mit der Auswertelogik 56 realisiert werden soll, ist bevorzugt in Software implementiert, so dass zur weiteren Erläuterung in FIG 7 ein schematisch vereinfachtes Flussdiagramm 60 dargestellt ist, das eine Möglichkeit zur Implementation der Funktionalität der Auswertelogik 56 darstellt. Im Detail ist in FIG 7 gezeigt, dass das vom Filter 52 gelieferte Ausgangssignal (nämlich die Reflektion 34, aus der ein gespeichertes Nutzdatensendesignal herausgefiltert ist) an die Auswertelogik 56 übergeben und dort für eine weitere Verarbeitung dem durch das Flussdiagramm 60 dargestellten Algorithmus zur Verfügung gestellt wird. Nach einem Start des Algorithmus in einem ersten Block 62, in dem insbesondere die üblichen Initialisierungen durchgeführt werden, wird eine Pegelauswertungsroutine 64 aufgerufen, die bestimmt und vorgesehen ist, einzelne Pegel in dem vom Filter 52 gelieferten Signal zu erkennen und/oder den Übergang zwischen zwei aufeinander folgenden Pegeln, also einem Pegelwechsel, zu erkennen. Ausgehend von den von der Pegelüberwachungsroutine 64 gelieferten Ergebnissen wird im weiteren Verlauf des Algorithmus für den Fall, dass das Vorkommen eines Idle-Symbols 38 (FIG 5) als Signatur 36 (FIG 2) untersicht werden soll, in einer ersten Fallunterscheidung 66 überprüft, ob in dem vom Filter 52 gelieferten Signal zwei aufeinander folgende gleiche Pegelwechsel vorkommen. Ist dies nicht der Fall, wird also z.B. für zwei aufeinander folgende Takte nur ein Pegelwechsel und danach ein unveränderter Pegel festgestellt, verzweigt der Algorithmus wieder vor die Pegelauswertungsroutine 64. Sind dagegen zwei aufeinander folgende gleiche Pegelwechsel in der ersten Fallunterscheidung 66 erkannt, verzweigt der Algorithmus zu einer zweiten Fallunterscheidung 68, mit der überprüft wird, ob im Anschluss an die mit der ersten Fallunterscheidung 66 erkannten beiden aufeinander folgenden gleichen Pegelwechsel nochmals zwei aufeinander folgende gleiche Pegelwechsel, insbesondere zwei aufeinander folgende antivalente Pegelwechsel, in dem vom Filter 52 gelieferten Signal vorkommen. Ist dies nicht der Fall, verzweigt der Algorithmus erneut vor die Pegelauswertungsroutine 64. Sind dagegen erneut zwei aufeinander folgende gleiche Pegelwechsel erkannt, wird in einer nachfolgenden ersten Signalisierungsstufe 70 ein Zähler inkrementiert oder auf einen vorgegebenen Startwert gesetzt und ggf. ein erstes Signal 72 erzeugt, das an einem Ausgang der Auswertelogik 56 als Ausgangssignal 58 abgreifbar ist.

Im Anschluss an die erste Signalisierungsstufe 70 wird als weitere Fallunterscheidung eine Schwellwertüberwachung 74 aufgerufen, mit der überprüft wird, wie oft hintereinander die beiden durch die erste und zweite Fallunterscheidung 66, 68 repräsentierten Bedingungen erfüllt waren. Die aufeinander folgende Erfüllung der beiden durch die erste und zweite Fallunterscheidung 66, 68 repräsentierten Bedingungen deutet auf eine potentielle Erkennung eines Idle-Symbols 38 (FIG 5) als Signatur 36 (FIG 2) hin. Wenn allerdings das Nutzdatensendesignal 18 (FIG 6) z.B. das Symbol "9" und daran anschließend das Symbol "0" oder das Symbol "B" und daran anschließend das Symbol "0" umfasst, ergibt sich in der 4B5B-MLT-3-Kodierung eine gleiche Anzahl logischer Einsen, wie diese für das Idle-Symbol 38 charakteristisch ist. Insoweit ist durch das Erkennen zweier aufeinander folgender gleicher Pegelwechsel und zweier unmittelbar daran anschließender gleicher antivalenter Pegelwechsel eine noch nicht hinreichende Bedingung für die Erkennung eines Idle-Symbols 38 als Signatur 36 in der Reflektion 34 gegeben.

Wenn jedoch das ursprüngliche Nutzdatensendesignal 18 und entsprechend im Falle einer Störstelle 32 auch die sich dann ergebende Reflektion 34 aufeinander folgend zwei Idle-Symbole 38 als Signatur 36 umfasst, werden die durch die ersten beiden Fallunterscheidungen 66, 68 repräsentierten Bedingungen zweimal hintereinander als erfüllt erkannt. Es wird als zweimal hintereinander die erste Signalisierungsstufe 70 erreicht und entsprechend erreicht der von der ersten Signalisierungsstufe 70 beeinflusste Zähler zumindest den Wert "zwei". Dieser Zähler kann also mit der Schwellwertüberwachung 74 auf einen z. B. mit dem Zahlenwert "zwei" initialisierten Schwellwert verglichen werden, so dass im Falle zweier aufeinander folgender Idle-Symbole 38 in der Reflektion 34 auch die zweite Auswertestufe 76 erreicht wird, bei deren Erreichen zumindest ein Idle-Symbol 38 sicher erkannt ist. Dazu wird dann ein zweites Signal 78 erzeugt, das als erkanntes Vorhandensein einer Störstelle 32 auf dem Kommunikationsmedium 10 auswertbar ist. Als Ausgangssignal 58 wird also zumindest das zweite Signal 78 weitergegeben, ggf. auch das erste Signal 72.

Nicht berücksichtigt bei den bisherigen Erläuterungen ist der Umstand, dass das Nutzdatensendesignal (FIG 6) durch eine nicht gezeigt Umsetzeinheit, z.B. einen so genannten "Scrambler", modfiziert werden kann. In einem solchen modifizierten Nutzdatensendesignal wäre ein z.B. als Signatur 36 verwendetes Idle-Symbol 38 nicht mehr direkt erkennbar. Daraus folgt, dass das Idle-Symbole entsprechend auch in der Reflektion 34 nicht mehr unmittelbar erkennbar wäre. Allerdings arbeitet auch eine solche Umsetzeinheit, selbst wenn als Modifikation eine Verschlüsselung mit Pseudo-Zufallszahlen vorgesehen ist, nach einem vorgegebenen Algorithmus, so dass für die Verwendbarkeit des hier beschriebenen Verfahrens lediglich die inverse Anwendung des mit der Umsetzeinrichtung implementierten Algorithmus, z.B. im Anschluss an den Abgriff 50, erforderlich ist. Durch diese inverse Anwendung werden die Veränderung, die die Umsetzeinrichtung an dem Nutzdatensendesignal vornimmt, wieder rückgängig gemacht, so dass wieder Verhältnisse vorliegen, wie sie für die sonstige Beschreibung der Erfindung vorausgesetzt wurden.

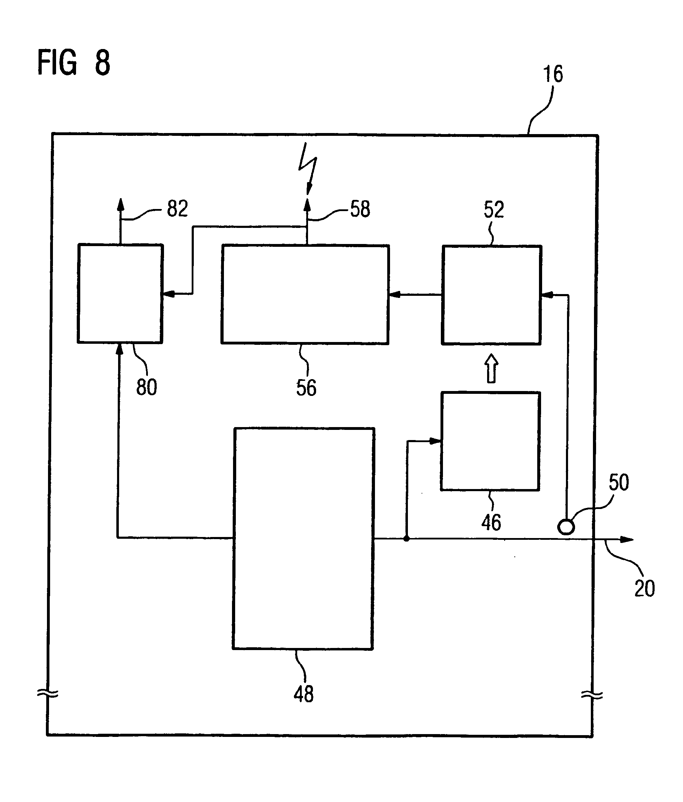

FIG 8 zeigt auf der Basis der Darstellung in FIG 6 bisher nicht erläuterte Details einer besonders bevorzugten Ausführungsform der Endeinrichtung 16, wobei in FIG 6 bereits beschriebene Einzelheiten nicht erneut thematisiert werden und insoweit auf die bereits erfolgte Beschreibung verwiesen wird. Die zusätzliche Funktionalität der Endeinrichtung 16 ist eine Laufzeitüberwachung 80, mit der eine Positionsinformation 82 zur örtlichen Lokalisierung der Störstelle 32 entlang des Kommunikationsmediums 10 generierbar ist. Der Laufzeitüberwachung 80 wird ein Startsignal von der Umwandlungseinheit 48 zugeführt, woraufhin ein von der Laufzeitüberwachung 80 umfasster, nicht dargestellter Zähler gestartet wird. Dieser Zähler wird wieder gestoppt, wenn die Auswertelogik 56 ein Ausgangssignal 58 generiert. Die durch den Zählerstand repräsentierte Zeitspanne entspricht der Summe der Laufzeit, die das Nutzdatensendesignal 18 ausgehend von der Endeinrichtung 16 bis zur Störstelle 32 benötigt zzgl. der Laufzeit der Reflektion 34, die diese von der Störstelle 32 bis zurück zur Endeinrichtung 16 benötigt hat. Entsprechend wird der Zählerstand halbiert, um ein Maß für die Entfernung der Störstelle 32 von der Endeinrichtung 16 zu erhalten, wobei bei bekannter Signalausbreitungsgeschwindigkeit diese durch den halbierten Zählerstand dividiert werden kann, um eine für einen Benutzer unmittelbar umsetzbare Positionsinformation 82 im Hinblick auf den Ort der Störstelle 32 zu generierten. Diese Positionsinformation 82 ist bei der für Ethernet vorgegebenen Taktung des Nutzdatensendesignals 18 auf ca. einen Meter genau.

Das Startsignal für die Laufzeitüberwachung 80 wird im Zusammenhang mit einer Generierung eines Pauseneinleitungssymbols durch die Umwandlungseinheit 48 erzeugt. Nachdem ein solches Pauseneinleitungssymbol bei einer Datenübertragung gemäß dem Ethernet-Standard Nutzdaten von nachfolgenden Idle-Symbolen 38 trennt, kann der Zeitpunkt der Generierung des Pauseneinleitungssymbols für den Start der Laufzeitüberwachung 80 herangezogen werden. Wenn die Erfindung bei einer Datenübertragung eingesetzt wird, die nicht dem Ethernet-Standard folgt, das Nutzdatensendesignal 18 also z.B. kein Pauseneinleitungssymbol umfasst, kann das Startsignal für die Laufzeitüberwachung 80 anhand des Zeitpunkts der Generierung der Signatur 36 abgeleitet werden.

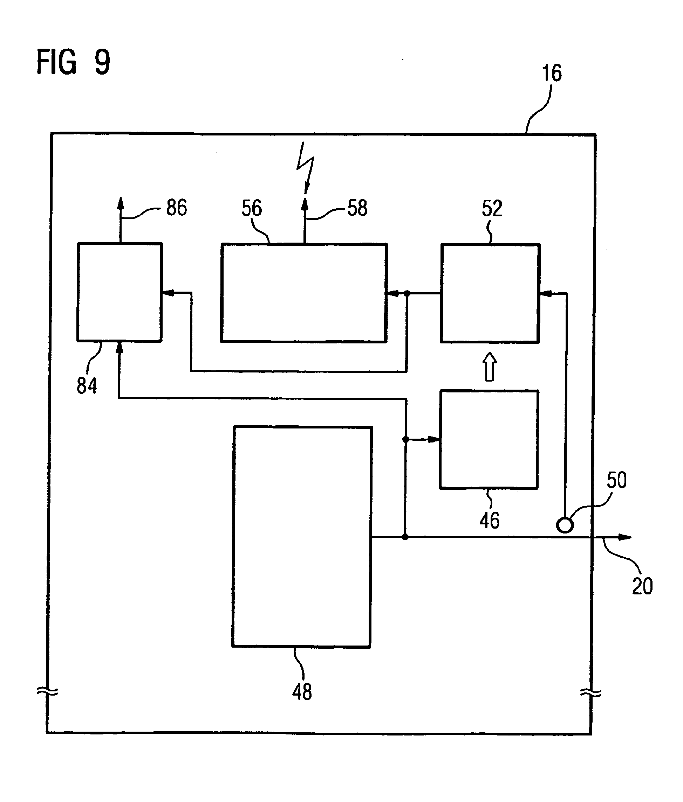

FIG 9 zeigt eine weitere bevorzugte Ausführungsform der Endeinrichtung 16, ebenfalls auf Basis der Darstellung in FIG 6, auf die in Bezug auf die bereits erläuterten Details verwiesen wird. Gemäß dieser Ausführungsform umfasst die Endeinrichtung 16 eine Flankenauswertungseinrichtung 84. Diese erhält für die Flankenauswertung als Eingangssignale einerseits den Ausgang der Umwandlungseinheit 48 und andererseits den Ausgang des Filters 52, so dass der Flankenauswertungseinrichtung 84 zur Verarbeitung das Nutzdatensendesignal 18 einerseits und die gefilterte Reflektion 34 andererseits zur Verfügung stehen. In beiden Signalen werden die darin enthaltenen Flanken gezählt, z.B. kontinuierlich oder zu vorgegebenen oder vorgebbaren Zeitpunkten für eine vorgegebene oder vorgebbare Zeitspanne. Die in den beiden betrachteten Signalen enthaltenen Flanken können durch Bildung eines Quotienten in Relation zueinander gestellt werden. Eine geringe oder verschwindende Flankenanzahl in dem vom Filter 52 erhaltenen Signal deutet darauf hin, dass entlang des Kommunikationsmediums 10 keine Störstelle 32 vorhanden ist und ein insoweit gebildeter Quotient strebt entweder gegen 0 oder ∞. Mit einer darauf abstellenden Fallunterscheidung ist ein ein Störstellenanzahlsignal 86 als Ausgang der Flankenauswertung 84 generierbar, wobei das Störstellenanzahlsignal 86 für das vorstehend skizzierte Szenario einen Wert repräsentiert, der in einer weiteren Verarbeitung derart auswertbar ist, dass angezeigt wird, dass entlang des Kommunikationsmediums 10 keine Störstellen 32 vorliegen. Ist die Anzahl der Flanken in beiden betrachteten Signalen dagegen in etwa gleich groß, d.h. ergibt sich für den Quotienten ein Wert in der Nähe von Eins, so wird das Nutzdatensendesignal 18 im Wesentlichen vollständig reflektiert und eine solche vollständige Reflektion 34 deutet darauf hin, dass entlang des Kommunikationsmediums 10 genau eine Störstelle 32 vorlegt. Bei einem derartigen Quotienten kann also durch die Flankenauswertungseinrichtung 84 ein entsprechendes Störstellenanzahlsignal 86 generiert werden. Ist die Anzahl der Flanken in dem vom Filter 52 erhaltenen Signal deutlich größer als die Anzahl der Flanken in dem von der Umwandlungseinheit 48 erhaltenen Signal, lässt sich aus einem sich dann ergebenden Quotienten, der deutlich von Eins verschieden ist, aber weder 0 noch ∞ erreicht, ableiten, dass entlang des Kommunikationsmediums 10 eine Mehrzahl von Störstellen 32 vorzuliegen scheint. Auch in dieser Hinsicht kann ein entsprechendes Störstellenanzahlsignal 86 generiert werden. Nachdem es bei mehreren Störstellen 32 zu Mehrfach-Reflektionen kommt, steigt die Anzahl der Flanken überproportional an. Bei z.B. zwei oder drei Störstellen 32, wenn also die Anzahl der Flanken in dem vom Filter 52 erhaltenen Signal die Anzahl der Flanken in dem von der Umwandlungseinheit 48 erhaltenen Signal in etwa um das Zwei- bzw. Dreifache übersteigt, kann als Störstellenanzahlsignal 86 evtl. noch eine Information abgeleitet werden kann, die das voraussichtliche Vorhandensein zweier bzw. dreier Störstellen 32 repräsentiert. Bei einem noch größeren Missverhältnis zwischen den Flanken in den beiden betrachteten Signalen kann üblicherweise nicht mehr auf die Anzahl der ggf. vorliegenden Störstellen 32 geschlossen werden, so dass dann als Störstellenanzahlsignal 86 nur noch eine Information abgegeben wird, die das Vorhandensein einer Mehrzahl von Störstellen 32 entlang des Kommunikationsmediums 10 repräsentiert.

Die in FIG 8 und FIG 9 dargestellten Ausführungsformen der Endeinrichtung 16 sind alternativ oder kumulativ verwendbar, so dass sich als besonders bevorzugte Ausführungsform für die Endeinrichtung 16 eine nicht mehr separat dargestellte Variante ergibt, die sowohl die Laufzeitüberwachung 80 wie auch die Flankenauswertungseinrichtung 84 umfasst.

Die für die Endeinrichtung 16 dargestellten Funktionalitäten sind bevorzugt in Software oder in Soft- und/oder Firmware implementiert, so dass die Pegelauswertungsroutine 64 ein Beispiel für Mittel zum Erkennen bestimmter Pegel evtl. Reflektionen 34 auf dem Kommunikationsmedium 10 ist. Die erste Fallunterscheidung 66 ist ein Beispiel für Mittel zum Erzeugen einer ersten Statusinformation im Falle erkannter gleicher Pegelwechsel, wobei als Statusinformation hier eine interne Variable zu verstehen ist, die anzeigt, ob die erste Fallunterscheidung 66 erfüllt ist oder nicht und in Ansehung des jeweiligen Wertes der Statusinformation eine Verzweigung zur zweiten Fallunterscheidung 68 erlaubt. Die zweite Fallunterscheidung 68 ist ihrerseits ein Beispiel für Mittel zum Erzeugen einer zweiten Statusinformation im Falle erkannter gleicher antivalenter Pegelwechsel bei Vorliegen der ersten Statusinformation und die zweite Statusinformation ist entsprechend der vorstehenden Ausführungen entweder eine interne Variable, die anzeigt, ob die zweite Fallunterscheidung 68 erfüllt ist, oder das von der ersten Signalisierungsstufe 70 generierte erste Signal 72. Die erste Signalisierungsstufe 70 stellt schematisch vereinfacht eine Funktionalität dar, die einen Zähler umfasst, dessen Eingang die zweite Statusinformation zuführbar ist, der also durch den sich nur bei Erfülltheit der zweiten Fallunterscheidung 68 ergebenden Aufruf inkrementiert wird und dessen Wert durch die nachfolgende Schwellwertüberwachung 74 auf das Erreichen oder Überschreiten eines vorgegebenen Schwellwertes überwacht wird.

Zusammenfassend lässt sich die vorliegende Erfindung damit kurz wie folgt beschreiben: Es wird ein Verfahren zum Betrieb einer Endeinrichtung 16 wie sie für elektrische Geräte, insbesondere Automatisierungsgeräte, für deren Anschluss an ein Kommunikationsmedium vorgesehen ist, beschrieben, die im Betrieb ein Verfahren ausführt, mit dem Störstellen 32 entlang eines an die Endeinrichtung 16 anschließbaren Kommunikationsmediums 10 erkennbar sind und die die für die Ausführung dieses Verfahrens erforderlichen Mittel, also insbesondere eine Verarbeitungseinheit nach Art eines Prozessors und einen Speicher umfasst, in dem der Pufferspeicher 46, der Filter 52, die Auswertelogik 56 und optional die Laufzeitüberwachung 80 und/oder die Flankenauswertungseinrichtung 84 als Softwareimplementation hinterlegt sind, mit denen im Betrieb der Endeinrichtung 16 das im Anschluss an einen Sendevorgang eventuelle Reflektionen 34 auf dem Kommunikationsmedium 10 auf das Vorkommen einer vorgegebenen Signatur 36 überwacht werden, wobei zum Überwachen der Reflektion 34 auf das Vorkommen der Signatur 36 aus der Reflektion 34 ein gespeichertes Nutzdatensendesignal herausgefiltert wird und wobei im Falle einer Detektion der vorgegebenen Signatur 36 eine Störstelle 32 des Kommunikationsmediums 10 erkannt ist. Die Endeinrichtung 16 selbst zeichnet sich also durch das Vorhandensein der beschriebenen Funktionalitäten und deren vorgesehenes Zusammenwirken wie ebenfalls beschrieben aus. Der Ansatz gemäß der Erfindung eignet sich besonders zur Erkennung von Reflektionen und deren Position bei Fast Ethernet mit 1000 BASE-TX als Übertragungstechnik.

## Patentansprüche

1. Verfahren zum Betrieb einer Endeinrichtung (16) an einem für eine Datenübertragung, insbesondere eine Datenübertragung nach dem Ethernet-Protokoll, vorgesehenen Kommunikationsmedium (10),
wobei im Anschluss an einen Sendevorgang der Endeinrichtung (16) eventuelle Reflektionen (34) auf dem Kommunikationsmedium (10) auf das Vorkommen einer vorgegebenen Signatur (36) überwacht werden und
wobei im Falle einer Detektion der vorgegebenen Signatur (36) eine Störstelle (32) des Kommunikationsmediums (10) erkannt ist
**dadurch gekennzeichnet,**
**dass** zum Überwachen der Reflektion (34) auf das Vorkommen der Signatur (36) aus der Reflektion (34) ein gespeichertes Nutzdatensendesignal (18) herausgefiltert wird und
**dass** die vorgegebene Signatur (36) ein am Ende eines Sendevorgangs vorgesehenes Idle-Symbol (38) einer 4B5B MLT-3-Kodierung ist.

2. Verfahren nach Anspruch 1,
wobei eine Position der Störstelle (32) entlang des Kommunikationsmediums (10) aus einer vom Ende des Sendevorgangs bis zum Erkennen der Signatur (36) gemessenen hälftigen Signallaufzeit dividiert durch die Signalausbreitungsgeschwindigkeit auf dem Kommunikationsmedium (10) ermittelt wird.

3. Verfahren nach Anspruch 2,
wobei bei einer gleichsinnigen Erkennung der Signatur (36) in einer Reflektion (34) auf dem Kommunikationsmedium (10) die Störstelle (32) als offene Leitung und bei einer antivalenten Erkennung der Signatur (36) die Störstelle (32) als Kurzschluss erkannt wird.

4. Verfahren nach Anspruch 2 oder 3,
wobei Reflektionen (34) auf dem Kommunikationsmedium (10) auf das Vorkommen des Idle-Symbols (38) als Signatur (36) überwacht werden, indem eine Auswertelogik (56) im Falle zweier aufeinander folgender gleicher Pegelwechsel das unmittelbar daran anschließende Vorkommen zweier aufeinander folgender antivalenter Pegelwechsel überwacht.

5. Verfahren nach Anspruch 4,
wobei im Falle einer Erkennung auch zweier aufeinander folgender antivalenter Pegelwechsel ein Zähler inkrementiert wird und
wobei die Störstelle (32) als solche erkannt ist, wenn der Zähler einen vorgegebenen oder vorgebbaren Schwellwert erreicht.

6. Verfahren nach Anspruch 3, 4 oder 5,
- wobei nach einer Datenübertragung bei einem Übergang zu einer Sendepause ein Pauseneinleitungssymbol und daran anschließend zumindest zweimal oder fortdauernd bis zum Ende der Sendepause das Idle-Symbol (38) gesendet wird,
- wobei mit der Übertragung des Pauseneinleitungssymbols ein Zeitzähler gestartet wird, der mit dem Erkennen des Idle-Symbols (38) in einer eventuellen Reflektion (34) gestoppt wird und
- wobei der dann erhaltene Wert des Zeitzählers als Signallaufzeit verwendet wird.

7. Verfahren nach einem der vorangehenden Ansprüche,
- wobei in einem während des Sendevorgangs übermittelten Nutzdatensendesignal (18) davon umfasste Flanken und ebenfalls in einer eventuellen Reflektion (34) davon umfasste Flanken gezählt werden und ein Quotient gebildet wird,
- wobei bei einem Quotienten in der Nähe von Eins die Störung auf dem Kommunikationsmedium (10) und ein Fehlerort ausgegeben werden,
- wobei bei einem Quotienten, der klein gegen Eins ist, die Störung auf dem Kommunikationsmedium (10) als durch mehrere Störstellen (32) verursacht ausgegeben wird.

8. Computerprogramm mit durch einen Computer ausführbaren Programmcodeanweisungen zur Implementierung des Verfahrens nach einem der Ansprüche 1 bis 7, wenn das Computerprogramm auf einem Computer ausgeführt wird.

9. Speichermedium mit einem durch einen Computer ausführbaren Computerprogramm gemäß Anspruch 8.

10. Endeinrichtung (16) zum Betrieb an einem für eine Datenübertragung, insbesondere eine Datenübertragung nach dem Ethernet-Protokoll, vorgesehenen Kommunikationsmedium (10) mit Mitteln (46,48,50,52,56,60) zum Ausführen des Verfahrens nach einem der Ansprüche 1 bis 7.

11. Endeinrichtung (16) nach Anspruch 10 mit einer Verarbeitungseinheit und einem Speicher als Mittel zum Ausführen des Verfahrens nach einem der Ansprüche 1 bis 8, wobei in den Speicher ein Computerprogramm nach Anspruch 9 geladen ist.

12. Endeinrichtung (16) nach Anspruch 10 oder 11, mit einem Pufferspeicher (46) in dem während eines Sendevorgangs der Endeinrichtung (16) übermittelte Daten als Nutzdatensendesignal (18) speicherbar sind und einem Filter (52), mit dem das im Pufferspeicher (46) vorgehaltene Nutzdatensendesignal (18) aus der Reflektion (34) herausfilterbar ist.

13. Endeinrichtung (16) nach Anspruch 10, 11 oder 12, mit einer Auswertelogik (56) mit
- Mitteln zum Erkennen bestimmter Pegel eventueller Reflektionen (34) auf dem Kommunikationsmedium (10),
- Mitteln zum Erkennen zweier aufeinander folgender gleicher Pegelwechsel,
- Mitteln zum Erzeugen einer ersten Statusinformation im Falle erkannter gleicher Pegelwechsel,
- Mitteln zum Erzeugen einer zweiten Statusinformation im Falle erkannter gleicher antivalenter Pegelwechsel bei Vorliegen der ersten Statusinformation und
- Mitteln zur Weiterverarbeitung der zweiten Statusinformation.

14. Endeinrichtung (16) nach Anspruch 13,
- wobei zur Weiterverarbeitung der zweiten Statusinformation diese einem Zähler an dessen Eingang zuführbar ist und
- wobei dem Zähler eine Schwellwertüberwachung (74) nachgeschaltet ist, mit dem, wenn im Betrieb der Zähler einen der Schwellwertüberwachung (74) vorgegebenen oder vorgebbaren Schwellwert erreicht ein eine Störstelle (32) auf dem Kommunikationsmedium (10) anzeigendes Ausgangssignal (58) generierbar ist.

## Claims

1. Method for operating a terminal device (16) on a communication medium (10) intended for data transmission, in particular data transmission according to the Ethernet protocol,
wherein, following a transmission process of the terminal device (16), possible reflections (34) on the communication medium (10) are monitored for the occurrence of a predefined signature (36), and
wherein a fault (32) of the communication medium (10) is identified if the predefined signature (36) is detected, **characterized**
**in that**, in order to monitor the reflection (34) for the occurrence of the signature (36), a stored useful data transmission signal (18) is filtered from the reflection (34), and
**in that** the predefined signature (36) is an idle symbol (38) of 4B5B MLT-3 coding, which symbol is provided at the end of a transmission process.

2. Method according to Claim 1,
wherein a position of the fault (32) along the communication medium (10) is determined from half the signal propagation time, measured from the end of the transmission process to the detection of the signature (36), divided by the signal propagation speed on the communication medium (10).

3. Method according to Claim 2,
wherein the fault (32) is identified as an open line if the signature (36) is detected in a reflection (34) on the communication medium (10) in the same direction and is identified as a short circuit if the signature (36) is detected in an antivalent manner.

4. Method according to Claim 2 or 3,
wherein reflections (34) on the communication medium (10) are monitored for the occurrence of the idle symbol (38) as a signature (36) by virtue of an evaluation logic unit (56) monitoring, in the event of two successive identical level changes, the immediately following occurrence of two successive antivalent level changes.

5. Method according to Claim 4,
wherein a counter is incremented if two successive antivalent level changes are also detected, and
wherein the fault (32) is identified as such when the counter reaches a predefined or predefinable threshold value.

6. Method according to Claim 3, 4 or 5,
- wherein, following data transmission and in the event of a transition to a transmission pause, a pause introduction symbol is transmitted, and following the latter, the idle symbol (38) is transmitted at least twice or continuously until the end of the transmission pause,
- wherein a time counter is started with the transmission of the pause introduction symbol, which counter is stopped when the idle symbol (38) is detected in a possible reflection (34), and
- wherein the value of the time counter then obtained is used as the signal propagation time.

7. Method according to one of the preceding claims,
- wherein edges of a useful data transmission signal (18) transmitted during the transmission process are counted in said signal and edges of a possible reflection (34) are likewise counted in said reflection and a quotient is formed,
- wherein the fault on the communication medium (10) and a fault location are output in the case of a quotient in the vicinity of one,
- wherein the disturbance on the communication medium (10) is output as being caused by a plurality of faults (32) in the case of a quotient which is small in comparison with one.

8. Computer program having program code instructions which can be executed by a computer and are intended to implement the method according to one of Claims 1 to 7 when the computer program is executed on a computer.

9. Storage medium having a computer program according to Claim 8 which can be executed by a computer.

10. Terminal device (16) for operation on a communication medium (10) intended for data transmission, in particular data transmission according to the Ethernet protocol, having means (46, 48, 50, 52, 56, 60) for carrying out the method according to one of Claims 1 to 7.

11. Terminal device (16) according to Claim 10, having a processing unit and a memory as means for carrying out the method according to one of Claims 1 to 8, wherein a computer program according to Claim 9 is loaded into the memory.

12. Terminal device (16) according to Claim 10 or 11, having a buffer memory (46), which can store data transmitted during a transmission process of the terminal device (16) as a useful data transmission signal (18), and a filter (52) which can be used to filter the useful data transmission signal (18) held in the buffer memory (46) from the reflection (34).

13. Terminal device (16) according to Claim 10, 11 or 12, having an evaluation logic unit (56) with
- means for detecting particular levels of possible reflections (34) on the communication medium (10),
- means for detecting two successive identical level changes,
- means for generating a first item of status information in the event of detected identical level changes,
- means for generating a second item of status information in the event of detected identical antivalent level changes if the first item of status information is present, and
- means for processing the second status information further.

14. Terminal device (16) according to Claim 13,
- wherein, in order to process the second status information further, the latter can be supplied to the input of a counter, and
- wherein a threshold value monitoring means (74) is connected downstream of the counter, which monitoring means can be used to generate an output signal (58) which indicates a fault (32) on the communication medium (10) when, during operation, the counter reaches a threshold value which is predefined or can be predefined for the threshold value monitoring means (74).

## Revendications

1. Procédé pour faire fonctionner un terminal ( 16 ) sur un moyen ( 10 ) de communication prévu pour une transmission de données, notamment pour une transmission de données suivant le protocole éthernet,
dans lequel, à la suite d'une opération d'émission du terminal ( 16 ), on contrôle l'apparition d'une signature ( 36 ) prescrite dans des réflexions ( 34 ) éventuelles sur le moyen ( 10 ) de communication, et
dans lequel, dans le cas d'une détection de la signature ( 36 ) prescrite, on reconnaît une discontinuité ( 32 ) du moyen ( 10 ) de communication
**caractérisé,**
**en ce que**, pour le contrôle de l'apparition de la signature ( 36 ) dans la réflexion ( 34 ), on élimine par filtrage de la réflexion ( 34 ) un signal ( 18 ) d'émission de données utiles mémorisé et
**en ce que** la signature ( 36 ) prescrite est un symbole ( 38 ) idle, prévu à la fin d'une opération d'émission, d'un codage 4B5B-MLT-3.

2. Procédé suivant la revendication 1,
dans lequel on détermine une position de la discontinuité ( 32 ) le long du moyen ( 10 ) de communication à partir d'une demi-durée de parcours du signal, mesurée de la fin de l'opération de l'opération d'émission jusqu'à la détection de la signature ( 36 ), divisée par la vitesse de propagation du signal sur le moyen ( 10 ) de communication.

3. Procédé suivant la revendication 2,
dans lequel, pour une détection de même sens de la signature ( 36 ) dans une réflexion ( 34 ) sur le moyen ( 10 ) de communication, on détecte la discontinuité ( 32 ) sous la forme d'une ligne ouverte et, pour une détection antivalente de la signature ( 36 ), on détecte la discontinuité ( 32 ) sous la forme d'un court-circuit.

4. Procédé suivant la revendication 2 ou 3,
dans lequel on contrôle l'apparition du symbole idle ( 38 ) comme signature ( 36 ) dans des réflexions ( 34 ) sur le moyen ( 10 ) de communication par le fait qu'une logique ( 56 ) d'exploitation contrôle, dans le cas de deux changements de niveau identiques successifs, l'apparition qui s'ensuit immédiatement de deux changements de niveau antivalents successifs.

5. Procédé suivant la revendication 4,
dans lequel, dans le cas d'une détection de deux changements de niveau antivalents successifs, on incrémente un compteur et dans lequel on reconnaît la discontinuité ( 32 ) en tant que tel lorsque le compteur atteint une valeur de seuil prescrite ou qui peut l'être.

6. Procédé suivant la revendication 3, 4 ou 5,
- dans lequel après une transmission de données, lors d'un passage à un intervalle entre les émissions, on émet un symbole de commencement d'intervalle et ensuite au moins deux fois ou d'une manière continue jusqu'à la fin de l'intervalle entre les émissions, le symbole idle ( 38 )
- dans lequel on fait démarrer, avec la transmission du symbole de commencement d'intervalle, un compteur de temps qui est arrêté avec la détection du symbole idle ( 38 ) dans une réflexion ( 34 ) éventuelle et
- dans lequel on utilise la valeur alors obtenue du compteur de temps, comme temps de parcours du signal.

7. Procédé suivant l'une quelconque des revendications précédentes
- dans lequel on compte dans un signal ( 18 ) d'émission de données utiles transmis pendant l'opération d'émission des fronts qui y sont compris et également dans une réflexion ( 34 ) éventuelle des fronts qui y sont compris, et on forme un quotient,
- dans lequel on indique pour un quotient proche de 1, la panne sur le moyen ( 10 ) de communication et un lieu de défaut
- dans lequel, pour un quotient qui est plus petit que ( 1 ), on indique que la panne sur le moyen ( 10 ) de communication est provoquée par plusieurs discontinuités ( 32 ).

8. Programme informatique ayant des instructions de code de programme pouvant être réalisées par un ordinateur pour la mise en oeuvre du procédé suivant l'une des revendications 1 à 7, lorsque programme informatique est réalisé sur un ordinateur.

9. Support de mémoire comprenant un programme informatique suivant la revendication 8 pouvant être réalisé par un ordinateur.

10. Terminal ( 16 ) destiné à fonctionner sur un moyen ( 10 ) de communication prévu pour une transmission de données, notamment pour une transmission de données suivant le protocole éthernet, comprenant des moyens ( 46, 48, 50, 52, 56, 60 ) de mise en oeuvre du procédé suivant l'une des revendications 1 à 7.

11. Terminal ( 16 ) suivant la revendication 10, comprenant une unité de traitement et une mémoire comme moyen de réalisation du procédé suivant l'une des revendications 1 à 8, un programme informatique suivant la revendication 9 étant chargé dans la mémoire.

12. Terminal ( 16 ) suivant la revendication 10 ou 11, comprenant une mémoire ( 46 ) tampon, dans laquelle pendant une opération d'émission du terminal ( 6 ) des données transmises peuvent être mémorisées sous la forme d'un signal ( 18 ) d'émission de données utiles et un filtre ( 52 ), par lequel le signal ( 18 ) d'émission de données utiles mis en réserve dans la mémoire ( 46 ) tampon peut être éliminé de la réflexion ( 34 ) par filtrage.

13. Terminal ( 16 ) suivant la revendication 10, 11 ou 12, comprenant une logique ( 56 ) d'exploitation comprenant
- des moyens de détection d'un niveau déterminé de réflexions ( 34 ) éventuelles sur le moyen ( 30 ) de communication,
- des moyens de détection de deux changements de niveau identique successifs,
- des moyens de production d'une première information de statut dans le cas de la détection d'un changement de niveau identique,
- des moyens de production d'une deuxième information de statut dans le cas de la détection d'un changement de niveau antivalent identique en la présence de la première information de statut et
- des moyens de traitement ultérieur de la deuxième information de statut.

14. Terminal ( 16 ) suivant la revendication 13,
- dans lequel pour le traitement ultérieur de la deuxième information de statut celle-ci peut être envoyée à l'entrée d'un compteur et
- dans lequel un contrôle ( 74 ) de valeur de seuil est monté en aval du compteur, contrôle par lequel, lorsqu'en fonctionnement du compteur, une valeur de seuil prescrite ou pouvant l'être par le contrôle ( 74 ) de valeur de seuil est atteinte, un signal ( 58 ) de sortie indiquant une discontinuité ( 32 ) sur le moyen ( 10 ) de communication peut être produit.
